# EUROPEAN PATENT APPLICATION

(11) **EP 2 428 820 A2**
(43) Date of publication of application: **14.03.2012**
(21) Application number: 10193436.2
(22) Date of filing: 02.12.2010
(51) Int. Cl.: G01T 1/20

(54) **Silicon photomultiplier and radiation detector**

(30) Priority: 13.09.2010 EP 10009502
(71) Applicant: SIEMENS AKTIENGESELLSCHAFT, 80333 München (DE)
(72) Inventor: Hedler, Harry, 82110, Germering (DE); Henseler, Debora, 91054, Erlangen (DE)

(57) **Abstract**

The invention relates to a silicon photomultiplier (20; 20'; 20''; 62) with a silicon chip (22) comprising an array of microcells (21), wherein the microcells (21) form photon-sensitive active areas (23), each surrounded by photon-insensitive inactive areas (24). At least one elevated, three-dimensional light concentrating structure (27; 27'; 27''; 63) is located directly on top of the Silicon chip (22) within an inactive area (24) and configured such that photons that would have hit an inactive area (24) are redirected towards an active area (23).

The light concentrating structure does lead to increased detection efficiency. The inventive SiPM is usable in areas like medical imaging (e.g. PET, SPECT, CT and other X- ray detectors) as well as astrophysics, high-energy physics and other analytic applications.

## Description

The invention relates to a silicon photomultiplier with a silicon chip comprising an array of microcells, wherein the microcells form photon-sensitive active areas, each surrounded by photon-insensitive inactive areas. The invention further relates to a radiation detector with a scintillator and a silicon photomultiplier according to the invention.

Silicon photomultipliers (SiPMs) are solid-state photo sensors that have been developed for very low-level light sensing applications. They consist of an array of microcells, which are each operated in so-called Geiger mode. These devices have been commercially available for a few years now, and they are well suited for applications in medical imaging, such as Positron Emission Tomography (PET), Single Photon Emission Computed Tomography (SPECT) and Computed Tomography (CT). They generally have reasonably high detection efficiencies, high signal-to-noise ratios due to their internal gain and short pulse widths of a few ns. Promising results on the use of SiPMs for PET have been published in recent years, e.g. in S. Seifert et al., "Ultra Precise Timing with SiPM-Based TOF PET Scintillation Detectors", 2009, IEEE Nuclear Science Symposium Conference Record; D. Henseler et al., "SIPM Performance in PET Applications: An Experimental and Theoretical Analysis", 2009, IEEE Nuclear Science Symposium Conference Record and T. Frach et al., "The Digital Silicon Multiplier - Principle of Operation and Intrinsic Detector Performance", 2009, IEEE Nuclear Science Symposium Conference Record.

The most common PET scintillators Lutetiumoxyorthosilicate (LSO) and Lutetiumyttriumoxoorthosilicate (LYSO) emit light in the blue part of the visible spectrum, with a peak emission around 420 nm. The photon detection efficiency (PDE) of SiPMs is normally between 10% and 50% in this wavelength range. The higher-efficient devices compare favourably with classical photomultiplier tubes (PMTs), which have quantum efficiencies of around 25%. But other silicon based devices like regular APDs or blue-enhanced pin diodes (positive intrinsic negative diodes) easily reach quantum efficiencies as high as 80-85%. The PDE of a SiPM is lower mainly because of the limited active area fill factor and also due to a limited avalanche probability.

The area fill factor in an analogue SiPM is limited by the space taken up by gaps between the microcells and also by the space for a quenching resistor, typically made of polysilicon material. In a digital SiPM, space is taken up by the cell gaps and a set of transistors (see T. Frach et al., "The Digital Silicon Multiplier - Principle of Operation and Intrinsic Detector Performance", 2009, IEEE Nuclear Science Symposium Conference Record).

The loss in PDE due to the inactive regions matters especially for PET, because the coincidence time resolution of a scintillation event is a strong function of the number of detected photons n. In a first approximation, the coincidence resolving time is proportional to 1/sqrt(n). The photon yield also has a strong impact on the energy resolution of the pulse height spectrum and on the spatial resolution of an event, which is relevant for both PET and SPECT applications. A high light yield is also important for many other applications like Computed Tomography, astrophysics and high energy physics experiments.

In most commercially available SiPMs, the width of the cell gaps are between 5 and 15 µm, and the quenching resistor takes up another few 10 to a few 100 µm² per cell. The gaps are required to electrically isolate the active regions from each other, but also to accommodate the contact lines for bias and/or signal contacts and in some cases other features like optical isolation trenches or guard structures. A high PDE can generally be achieved if a relatively large cell pitch is used, because then the area fractions for the gaps and quench resistors are lower (see table below, which shows known device parameters for 3x3 mm² SiPMs with different cell sizes).

| cell size | 25 x 25 µm² | 50 x 50 µm² | 100 x 100 µm² |
|---|---|---|---|
| active area fill factor | 30.8 % | 61.5 % | 78.5 % |
| photon detection efficiency (PDE) | 25% | 50% | 65% |
| number of cells per device | 14400 | 3600 | 900 |

On the other hand, most applications require a minimum number of microcells, because saturation effects will occur if the number of microcells is of the same order as the number of impinging photons. This saturation leads to degradation of the energy resolution. Another disadvantage of very large cells is the high cell capacitance and the resulting broader pulse response, which has a negative effect on the time resolution.

Depending on the application, the relevant signal levels and the linearity requirements, there is usually an optimum cell size that gives the best performance level: For studies on PET applications, the 50 µm cell size is most commonly used. It seems to give the best trade-off for the average signal levels for 511 keV radiation after conversion to visible light by standard PET scintillators.

The coating of the inactive parts of the SiPM with a reflective material (e.g. aluminium) has been suggested in P. Barton et al., "Effect of Surface Coating on Light Collection Efficiency and Optical Crosstalk for SSPM- Scintillation Detection", Nucl. Instr. Meth. Phys. Res. A 610 (2009) 393-396. Based on ray-tracing simulations by these authors, a significant increase in overall light yield was expected in particular for geometries with small fill factors. However, the simulations also predict an increase in the optical crosstalk between cells due to the additional reflector and therefore a further limitation to the useful bias voltage range. The use of such additional reflecting layers on the cell gaps has not yet become established in any commercial SiPMs. But the cell gaps of any existing device will at least be partially reflective, because the metal contact lines will introduce some reflectivity to parts of the inactive regions.

It is an object of the present invention to specify a silicon photomultiplier with improved detection efficiency.

The object is achieved by a silicon multiplier in accordance with the features of claim 1.

Accordingly, a silicon multiplier with a silicon chip comprises an array of microcells, wherein the microcells form photon-sensitive active areas, each surrounded by photon-insensitive inactive areas. According to the invention, the silicon multiplier further comprises at least one elevated, three-dimensional light concentrating structure located directly on top of the Silicon chip within an inactive area and configured such that photons that would have hit an inactive area are redirected towards an active area.

The key idea of the present invention is the design of a SiPM with three-dimensional light concentration structures, guiding incident light, e.g. light from a scintillator, to the active parts of the microcells. Thus, the purpose of these structures is to enhance the PDE of the SiPM by redirecting the photons that would have hit an inactive area towards an active area of the SiPM, which leads to a large increase of the detection efficiency (modelled by the total light yield of the SiPM).

Compared to a simple reflective coating, the above-described structures have the advantage that they do not lead to an increase in optical cross-talk between the microcells.

In contrast to the known approach of covering the inactive gaps with a reflective coating, the three-dimensional structures according to the invention not only lead to a higher increase of the overall efficiency, but they also result in large gains for the fraction of rays which have accumulated only short optical path length delays on their way to the active sensor part. This is particularly important for PET applications, where the time resolution is determined mainly by the light arriving within the first few 100 ps of a scintillation pulse.

For optimum performance in PET applications, special emphasis is placed on keeping the optical path lengths of the photons as short as possible before hitting the active part of the sensor. The reason is that large optical path lengths lead to additional time delays before detection and therefore to a deterioration of the time resolution. To achieve the most precise event timing information, the timing trigger should be derived from the first few photons, which arrive within the first few 100 ps of the emission pulse. These early photons have accumulated very short optical path lengths in the LSO and the optical coupling layers. In other words, the photons that are most relevant for the timing information are the ones that successfully hit the active sensor area without being reflected back into the scintillator a second time.

Apart from PET there will also be many other applications in different areas of medical imaging (e.g. SPECT, CT and other X- ray detectors) as well as astrophysics, high-energy physics and other analytics applications, where the increase in light yield (and especially the enhancement of early photons) will be a big advantage.

According to one embodiment of the invention the inactive areas of the SiPM are formed by cell gaps, which electrically isolate the microcells from each other, and by a frame area surrounding the array of microcells. Accordingly, the at least one light concentrating structure is located in the area of the cell gaps and/or the frame area.

The cell gaps can also accommodate contact lines for bias and/or signal contacts and in some cases other features like optical isolation trenches or guard structures.

In order to achieve an increase of the detection efficiency that is as large as possible a preferred embodiment of the invention provides at least one light concentrating structure, which completely covers the cell gaps and/or the frame area.

According to an embodiment of the invention, the at least one light concentrating structure is mounted on the Silicon chip and covered by an encapsulation material. Such an arrangement can be manufactured relatively simple, e.g. by a lithography process with subsequent isotropic etching.

According to another embodiment of the invention, the at least one light concentrating structure is a structured part of an encapsulation material, which is directly located on top of the Silicon chip. Such an arrangement can also be manufactured relatively simple, e.g. by a hot embossing process.

In a preferred embodiment of the invention, the at least one light concentrating structure has a basically triangular-like cross section. However, the light concentration structures could also have other geometric shapes, which can have higher collection efficiencies than the simple triangular structure. The most important example of an alternative geometry is a so-called compound parabolic concentrator (CPC), where the lateral surfaces, which serve as reflective walls or index boundaries, form sections of a parabola. The gradient of the CPC side wall at the light's entry aperture is very steep, ideally the walls are parallel to the detector normal at the top of the structure.

Both designs are easy to manufacture and result in large gains for the fraction of rays which have accumulated only short optical path length delays on their way to the active sensor part, which is particularly important for all applications, where the time resolution is determined mainly by the light arriving within the first few 100 ps of a light pulse.

In order to achieve a good reflectivity of the light concentrating structure the structure can comprise a reflective coating, in particular a metal coating. Alternatively, the at least one light concentrating structure can be made of a solid reflective material. In those implementations, where the light concentration structure is made of solid material, the material can be non-reflective at the bottom side and would therefore not enhance the reflection of IR light emitted within the SiPM.

In a further embodiment of the invention the at least one light concentrating structure is configured as a hollow three-dimensional structure, so that total internal reflection (TIR) can occur inside the encapsulation material, which covers the structure, at the borders of the structure, i.e. at the lateral surfaces of the hollow structure. At incidence angles that are steeper than the limiting TIR angle, the light can enter the hollow structure and travel through them, to eventually hit a neighbouring microcells.

The hollow structure can be filled-up with air or another material with a low refractive index so that total internal reflection can occur.

In a preferred embodiment the base of the hollow structure is coated with a reflective layer, so the light impinging there has another chance of being directed to the active region. Favourable, the reflective coating could be applied on top of an absorbing layer, so that the reflectivity from the silicon side is not increased.

The invention further provides a radiation detector with a scintillator and a silicon photomultiplier according to the invention coupled to the scintillator by at least one coupling material.

In order to increase the light yield, a refractive index of the coupling material preferably lies in the range of a refractive index of the scintillator.

According to one embodiment, the coupling material can be built by an encapsulation material containing the at least one light concentrating structure.

Further features and advantages of the present invention result from the hollowing description of preferred embodiments of the invention, which will now be described with reference to the drawings.

### Brief description of the drawings:

- Fig. 1: schematically shows a silicon photomultiplier (SiPM) as known from the state of the art in a top view;
- Fig. 2: schematically shows a cross section through a section of a SiPM according to a first embodiment of the invention;
- Fig. 3: schematically shows a cross section through a section of a SiPH according to a second embodiment of the invention;
- Fig. 4: schematically shows a cross section through a section of a SiPM according to a third embodiment of the invention; and
- Fig. 5: schematically shows a cross section through a section of a radiation detector according to an embodiment of the invention;

### Detailed description

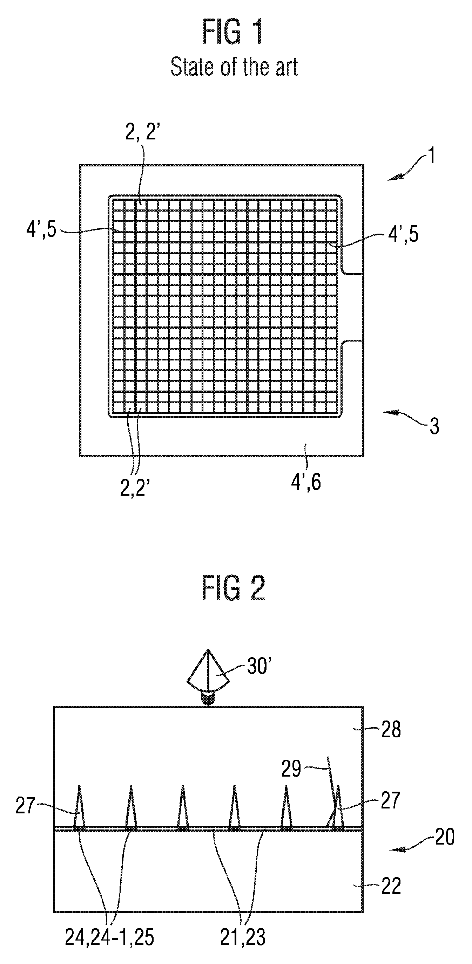

Figure 1 schematically shows a silicon photomultiplier 1 (SiPM) as it is known from the state of the art. The SiPM 1 comprises an array of microcells 2, which are built on a silicon chip 3. These microcells 2 form photon-sensitive active areas 2'. The active areas 2' are each surrounded by photon-insensitive inactive areas 4', which are formed by cell gaps 5, which electrically isolate the microcells 2 from each other, and by a frame area 6 surrounding the array of microcells 2.

Figure 2 schematically shows a cross section through a section of a SiPM 20 according to a first embodiment of the invention. Microcells 21 are built on a silicon chip 22 and form photon-sensitive active areas 23 of the SiPM 20. The active areas 23 and the microcells 21 respectively are each surrounded by photon-insensitive inactive areas 24, which are formed by cell gaps 25 and by a not shown frame area surrounding the array of microcells 21. The cell gaps 25 electrically isolate the microcells, 21 from each other and can also accommodate contact lines for bias and/or signal contacts and in some cases other features like poly-Silicon or metal quench resistors, transistors, optical isolation trenches or guard structures.

A three-dimensional light concentrating structure 27 is located directly on top of the silicon chip 22 within an inactive area 24-1 formed by the cell gaps 25. The light concentrating structure 27 is configured such that photons that would have hit the inactive area 24-1 are redirected towards an active area 23. Thereby, the light concentrating structure 27 completely covers the cell gaps 25. Therefore, in the shown typical SiPM configuration, where the microcells 21 form a two-dimensional array with the cell gaps 25 forming a two-dimensional rectangular grid, the light concentrating structure 27 is also a two-dimensional, interlaced grid. Figure 2 shows a fist embodiment, wherein the light concentrating structure 27 has a basically triangular-like cross section. The reflectivity of the structure's surface can for example be achieved by a reflective coating, e.g. in the form of a metallization layer. In this case the refractive index of the structure's material itself does not influence the optical properties much. Instead, the material can be chosen to allow optimal three-dimensional patterning and to provide a smooth seed layer for a high-reflectivity metal coating.

Alternative to a reflective coating, the light concentrating structure 27 itself can be made of a solid reflective material.

The light concentrating structure 27 is covered by an encapsulation material 28, which is directly located on top of the silicon chip 22. This can be achieved by integrating the light concentrating structure 27 between the silicon chip 22 and the encapsulation material 28, e.g. by a lithography process with subsequent isotropic etching. Alternatively, the light concentrating structure 27 can be a structured part of the encapsulation material 28 itself, which is directly located on top of the silicon chip 22. Such structuring can, for instance, be made by a hot embossing process.

Figure 2 shows a sample ray 29 of schematically indicated incident light 30, which comes, for instance, from a not shown scintillator. The ray 29 is hitting the light concentrating structure 27, which leads to a redirection of the ray 29 to the active area 23 of a microcell 21. Without the light concentrating structure 27 this sample ray 29 would have hit an inactive area 24 of a cell gap 25.

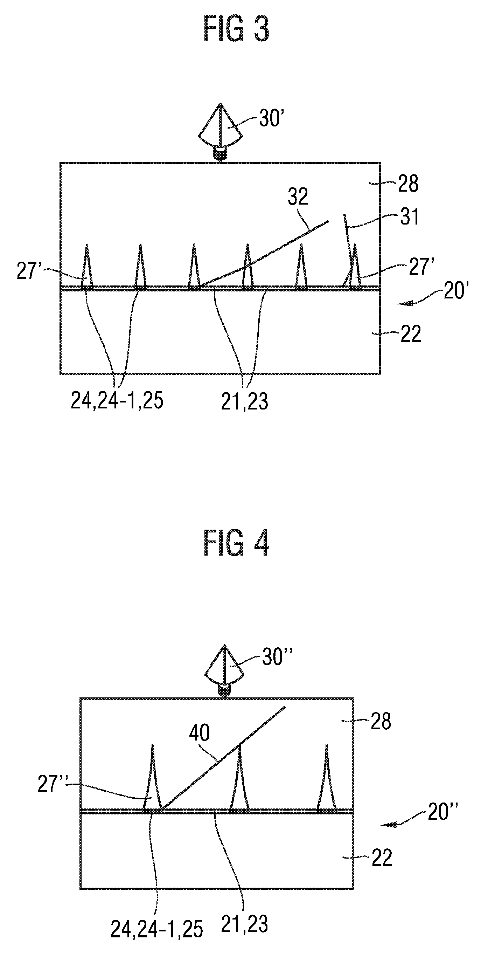

Figure 3 shows an alternative configuration of an SiPM 20', which differs from the first embodiment in that a light concentrating structure 27' is configured as a hollow three-dimensional structure, so that total internal reflection (TIR) can occur inside the encapsulation material 28 at the borders of the light concentrating structure 27'. At incidence angles that are steeper than a limiting TIR angle, the light can enter the light concentrating structure 27' and travel trough it, to eventually hit a neighbouring microcell 21. Favourable, the base of the hollow structure is coated with a reflective layer, so the light impinging there has another chance of being directed to an active area 23. The use of other, low-index materials instead of air would produce a similar effect.

Figure 3 shows two sample rays 31 and 32 of schematically indicated incident light 30'. These rays 31 and 32 are hitting the light concentrating structure 27', which leads to a redirection of the rays 31, 32 to active areas 23 of microcells, 21. Without the light concentrating structure 27 sample ray 31 would have hit an inactive area 24 of a cell gap 25.

Figure 4 shows an alternative configuration of an SiPM 20'', which differs from the first and second embodiment in that a light concentrating structure 27" has another geometric shape, which has a higher collection efficiency than a structure with a simple triangular-like cross-section with straight-lined lateral surfaces. The shown alternative geometry is a so-called compound parabolic concentrator (CPC), where the lateral surfaces (reflective walls or index boundaries) of the light concentrating structure 27'' form sections of a parabola. The gradient of the CPC lateral surfaces at the light's entry aperture is very steep, ideally the walls are parallel to the detector normal at the top of the structure. Similar to the geometry shown in figures 2 and 3, two-dimensional interlacing grids of structures with a CPC cross section would be formed.

In the shown example, the light concentrating structure 27" are formed by hollow compartments, so that the light is guided by total internal reflection inside the encapsulation material 28. Alternatively, the light concentrating structure 27'' can be filled with a low-index material, or the walls of the structure could be covered with a reflective coating (either as a coating on the wall of a hollow compartment or as a coating on a solid structure). As a further option, the CPC structures could also be made of solid, reflective material, in particular metal.

Figure 4 shows a sample ray 40 of schematically indicated incident light 30". The sample ray 40 hits at a limiting collection angle. All rays with steeper incidence than this angle will be collected by the CPC structure. At larger angles with the surface normal, a fraction of the rays can still be collected, depending on the exact position were they enter the concentrator structure.

In both implementations (hollow or filled structures), at least photons with steep incidence angle have a high chance of being (re-)directed to an active area 23.

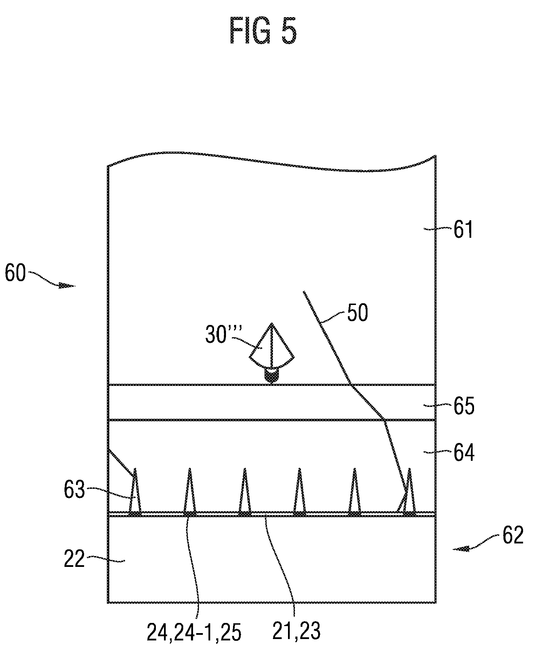

Figure 5 schematically shows a radiation detector 60 with a scintillator 61 configured, for instance, as an LSO or an LYSO and a SiPM 62 according to the invention. By way of example, a light concentrating structure 63 of the SiPM 62 is configured like the light concentrating structure 27 of figure 2. The light concentrating structure 63 is covered by an encapsulation material 64 and the SiPM 61 is coupled to the scintillator 61 by an additional coupling material 65.

Light extraction is made more difficult by a change of the refractive index from the scintillator, e.g. LSO with a refractive index of 1.82) to another refractive index of the coupling material. The light yield can generally be increased by matching the refractive index of the encapsulation material 64 and/or the coupling material 65 to that of the scintillator 61, so that the refractive index of the additional coupling material 65 and/or encapsulation material 64 lies in the range of the refractive index of the scintillator 61.

It has been found that the matching of the index or generally the increase of the refractive index of these two layers 64 and 65 is particularly advantageous in the presence of light concentration structures. The reason is that for a given incidence angle distribution in the scintillator, a lower-index encapsulation material 64 will lead to a broader angle distribution and a higher-index encapsulation material 64 will lead to a narrower angle distribution on the SiPM 61. If the angle distribution at the SiPM 61 is narrow and the rays enter at steep incidence angles, then a larger part of the distribution will be within the acceptance range of the light concentrating structure 63, and the light concentration is more effective. Therefore it is preferable to have a high-index material as the encapsulation material 64. The refractive index of the optical coupling material 65 matters for the light extraction of the scintillator, but the index of the encapsulation material 64 is even more relevant for controlling the fraction of rays within the acceptance angle of the light concentrating structure 63. By way of example, for an LSO scintillator a preferred range for the refractive index of the additional optical coupling material 65 is between 1.5 and 1.82, preferably 1.82, and for the encapsulation material 64 between 1.7 and 2.

Figure 5 shows a sample ray 50 of schematically indicated incident light 30'''. The sample ray 50 has an angle within the acceptance range of the light concentrating structure 63 after it enters the optically dense encapsulation material 64. But inside the less dense optical coupling material 65, the ray had a larger angle that may have been rejected by the light concentrating structure 63.

Alternative to the arrangement shown in figure 6, the SiPM 61 can be directly coupled to the scintillator 61 by the encapsulation material 64. In such an embodiment the encapsulation material 64 itself serves as a coupling material.

Alternatively to the shown embodiments, the light concentrating structure can cover the cell gaps only partially and/or can cover at least part of the frame area of the SIPM as well. Furthermore an SiPM according to the invention can comprise more than one light concentrating structures, which together cover the inactive areas of the SiPM completely or partially.

## Claims

1. Silicon photo-multiplier (20; 20'; 20''; 62) with a silicon chip (22) comprising an array of microcells, (21), wherein the microcells (21) form photon-sensitive active areas (23), each surrounded by photon-insensitive inactive areas (24), **characterized by** at least one elevated, three-dimensional light concentrating structure (27; 27'; 27''; 63) located directly on top of the Silicon chip (22) within an inactive area (24) and configured such that photons that would have hit an inactive area (24) are redirected towards an active area (23).

2. Silicon photomultiplier according to claim 1, **characterized in that** the inactive areas (24) are formed by cell gaps (25), which electrically isolate the microcells (21) from each other, and by a frame area surrounding the array of microcells (21) and that the at least one light concentrating structure (27; 27'; 27''; 63) is located in the area of the cell gaps (25) and/or the frame area.

3. Silicon photomultiplier according to claim 2, **characterized in that** the at least one light concentrating structure (27; 27'; 27''; 63) completely covers the cell gaps (25) and/or the frame area.

4. Silicon photomultiplier according to one of the preceding claims, **characterized in that** the at least one light concentrating structure (27; 27'; 27''; 63) is mounted on the silicon chip (22) and covered by an encapsulation material (28; 64).

5. Silicon photomultiplier according two one of clams 1 to 3, **characterized in that** the at least one light concentrating structure (27; 27'; 27''; 63) is a structured part of an encapsulation material (28; 64), which is directly located on top of the silicon chip (22).

6. Silicon photomultiplier according to claim 3, **characterized in that** the at least one light concentrating structure (27; 27'; 27''; 63) has a basically triangular-like cross section.

7. Silicon photomultiplier according to claim 6, **characterized in that** the at least one light concentrating structure (27; 27'; 27''; 63)has a basically triangular-like cross section, wherein the lateral surfaces form sections of a parabola.

8. Silicon photomultiplier according to one of the preceding claims, **characterized in that** the at least one light concentrating structure (27; 27'; 27''; 63) comprises a reflective coating, in particular a metal coating.

9. Silicon photomultiplier according to one of the preceding claims, **characterized in that** the at least one light concentrating structure (27; 27'; 27''; 63)is made of a solid reflective material.

10. Silicon photomultiplier according to one of the preceding claims, **characterized in that** the at least one light concentrating structure (27; 27'; 27''; 63) is configured as a hollow three-dimensional structure.

11. Silicon photomultiplier according to claim 10, **characterized in that** a base of the at least one light concentrating structure (27; 27'; 27''; 63) is coated with a reflective layer.

12. Silicon photomultiplier according to claim 10, **characterized in that** the hollow structure is filled-up with a material with a low refractive index so that total internal reflection can occur at the lateral surfaces of the hollow structure.

13. Radiation detector (60) with a scintillator, (61) and a silicon photomultiplier (62) according to one of claims 1 to 12 coupled to the scintillator (61) by at least one coupling material (64; 65).

14. Radiation detector according to claim 12, **characterized in that** a refractive index of the coupling material (64; 65) lies in the range of a refractive index of the scintillator (61).

15. Radiation detector according to claims 13 or 14, **characterized in that** the coupling material is built by an encapsulation material (65) containing the at least one light concentrating structure (63).
